# EUROPEAN PATENT APPLICATION

(11) **EP 2 316 788 A1**
(43) Date of publication of application: **04.05.2011**
(21) Application number: 09174516.6
(22) Date of filing: 29.10.2009
(51) Int. Cl.: B81C 1/00

(54) **MEMS device with electrosatic discharge protection**

(71) Applicant: NXP B.V., 5656 AG Eindhoven (NL)
(72) Inventor: Koning, Jan Jacob, Redhill, Surrey RH1 1DL (GB); El-Ghorba, Mehdi, Redhill, Surrey RH1 1DL (GB); Van Zwol, Johannes, Redhill, Surrey RH1 1DL (GB)
(74) Representative: Williamson, Paul Lewis

(57) **Abstract**

A method of making a bipolar transistor and/or an ESD device integrated onto the same substrate as the MEMS element uses a single additional mask and dopant step, to form the shallow well of second conductivity type. In particular, after forming a MEMS element (18) using a series of steps including forming a well of a first conductivity type and a step (24) of forming a shallow contact of the same first conductivity type at locations determined by a first mask, a bipolar transistor (16,42) and/or ESD protection device (16) is formed using a step of forming a shallow contact (8,10,40) ofopposite conductivity type at locations determined by a second mask.

## Description

The invention relates to a micro-electrical-mechanical system (MEMS) device and method of manufacture.

A MEMS device is typically formed on one semiconductor die with bond pads and attached to another device, for example an amplifier die, also with bondpads. Many types of MEMS device are known, but a typical device might be a resonator.

A problem can occur in such devices, since the pins on the MEMS device need electostatic discharge (ESD) protection. However, typical processes for making MEMS are too simple to implement ESD protection, such that electrostatic discharge leads to a significant loss in yield in such MEMS devices.

Another problem can occur in that parasitics to ground give a signal loss to ground. Therefore, when a MEMS device is driving an amplifier, the signal input to the amplifier is reduced which increases the noise in relation to the signal. MEMS devices are typically very small and give a very small signal, so this problem can be quite significant.

MEMS devices can be made relatively simply, with only two dopant steps, one to form a well, which can be masked or unmasked, and one highly doped shallow contact dope of the same polarity.

There is a problem in implementing conventional semiconductor processes such as CMOS processes in MEMS devices. The extra mask steps and process steps add significant complexity. Moreover, oxidation steps can cause problems if the CMOS steps take place after formation of the mechanical device, in particular oxidation of the mechanical device may occur. If the CMOS steps are carried out before the MEMS steps, the dopants in the CMOS may diffuse out in the light of the large thermal budget in MEMS manufacturing steps.

According to the invention, there is provided a method of manufacturing a MEMS device according to claim 1.

The method provides a bipolar transistor and/or an ESD device integrated onto the same substrate as the MEMS element. This is achieved using only a single additional mask and dopant step, to form the shallow well of second conductivity type. Thus, the method may easily be integrated into existing MEMS manufacturing methods.

The method may include forming a bipolar transistor with base, base contact, collector and emitter, the base being formed in the step of forming a well of first conductivity type and the base contact being formed in contact with the base in the step of forming a shallow contact of the same first conductivity type, and the collector and emitter being formed in the step of forming a shallow contact of second conductivity type, the collector and emitter being formed adjacent to the base.

An isolation trench may be formed around the bipolar transistor. This provides an isolated bipolar transistor without the need for additional masks or process steps.

The bipolar transistor may form an ESD protection device. This can protect the sensitive MEMS element from ESD using an integrally formed device (i.e. on the same substrate as the MEMS element).

Alternatively or additionally, the method may include forming a diode-type ESD protection device including a pn junction formed between the well of first conductivity type and the shallow contact of second conductivity type, again to protect the sensitive MEMS element from ESD using integrally formed ESD.

The method may further include providing a separate substrate with electronic circuitry and electrically connecting the separate substrate with electronic circuitry to the MEMS device on the MEMS substrate.

In another aspect, the invention relates to the MEMS device manufactured by the method, and in particular to a MEMS device comprising:
wells of a first conductivity type, shallow contacts of the same first conductivity type and at least one shallow contact of a second conductivity type;
comprising a MEMS element formed with at least one of the wells of a first conductivity type and contacts formed by the shallow contacts of the same first conductivity type; and
further comprising at least one bipolar transistor and/or ESD device formed with at least one of the wells of a first conductivity type, at least one shallow contact of a second conductivity type and at least one of the shallow contacts of the same first conductivity type contacting the at least one of the wells of a first conductivity type.

For a better understanding of the invention, embodiments will now be described, purely by way of example, with reference to the accompanying drawings, in which:
Figure 1 shows a layout of a bipolar transistor integrated with a MEMS device;
Figure 2 is a schematic of the manufacturing steps; and
Figure 3 shows a MEMS device together with an additional substrate; and
Figure 4 shows a layout of a protection diode integrated with a MEMS device.

The same or similar components are shown using the same reference numbers in Figures relating to different embodiments and the description relating to these components is not necessarily repeated.

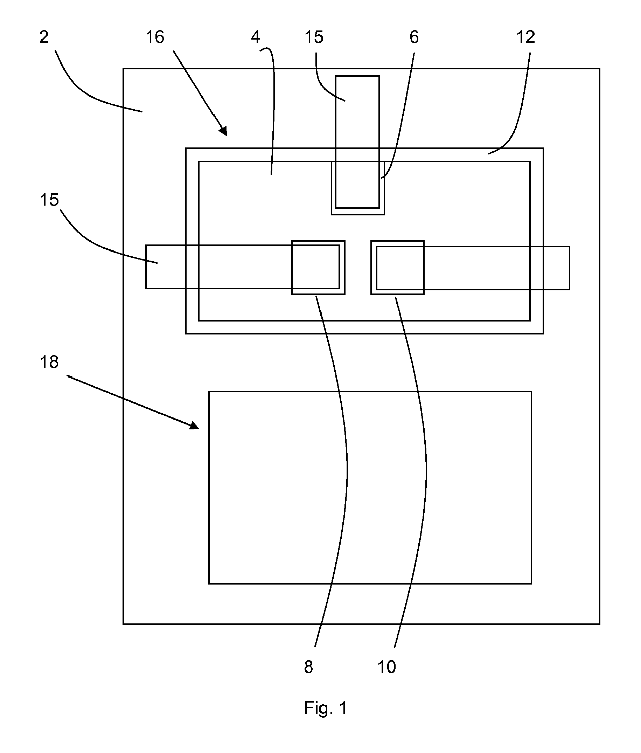

Referring to Figure 1, a suitable bipolar transistor 16 formed on substrate 2 is formed using a well of first conductivity type 4 as a base, a shallow well of the same first conductivity type 6 as a base contact and shallow wells of the opposite conductivity type 8,10 as collector and emitter. An isolation trench 12 is used to define and isolate the bipolar transistor. Metallisations 15 leading to bondpads (not shown in this figure) are used to connect to the base contact 6 as well as the collector 8 and emitter 10. A MEMS element 18 is also formed on the same substrate 2.

In terms of the layout of bipolar transistor 16, it is preferred that the base contact 6 is spaced away from the line of the collector and emitter since this allows the distance between the shallow wells 8, 10 of the collector and emitter to be relatively close, preferably less than 2 µm. This achieves a reasonable current amplification factor (h_{fe}). For a reasonable h_{fe} value of around 50, a base width of around 1 µm is suitable.

To manufacture a bipolar transistor 16, as well as the MEMS element 18 on the same substrate, the MEMS element is formed with a plurality of steps in an existing process. These steps include a step 20 of forming a trench, a step 22 forming a well doped to be of a first conductivity type (either n-type or p-type), and a step 24 forming a shallow contact doped to be of the same first conductivity type. The step 22 of forming a well can if required use a mask and resist. The step 24 forming the shallow contact does use a mask and resist. Since methods using masks to define and pattern MEMS elements are well known to those skilled in the art, they will not be defined further.

Please note that the order of the steps listed above can be varied as required.

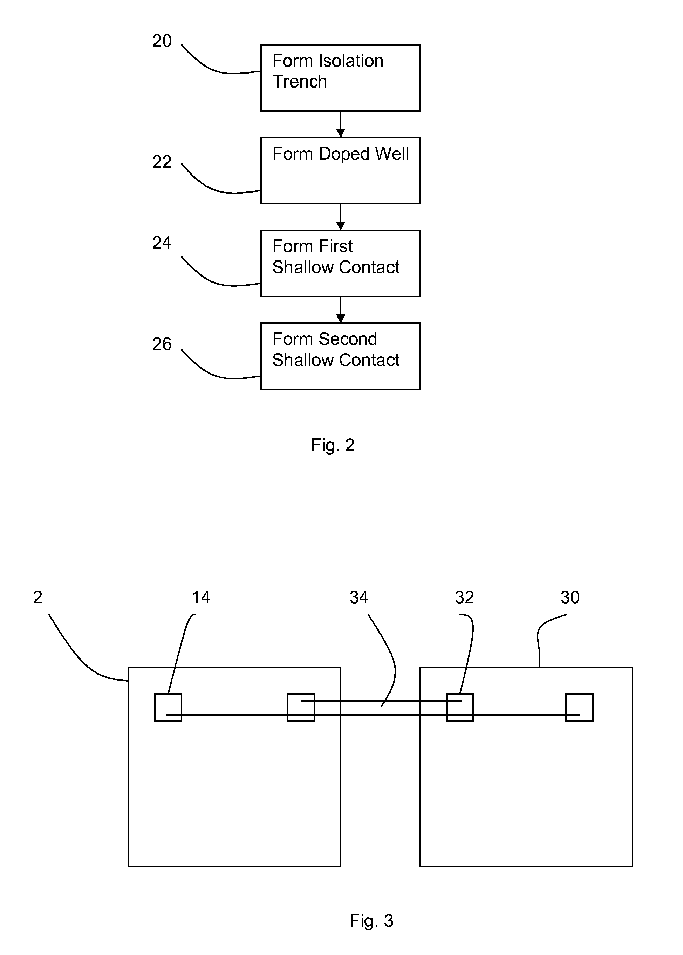

The bipolar transistor is formed using some of the same steps used to form the MEMS element as well as one additional step, step 26 forming a shallow contact of a second conductivity type opposite to the first conductivity type. Thus, the same process step 20 forming a trench in the MEMS element forms the isolation trench 12, the process step 22 forming the well of first conductivity type in the MEMS element forms the base 4, the process step 24 forming a shallow contact in the MEMS element forms the base contact 6, and the process step 26 forming a shallow contact of second conductivity type forms the collector 8 and emitter 10. The order of process steps is schematically shown in Figure 2.

A further step 28 forms bondpads 14.

As illustrated in Figure 3, a separate substrate 30 is provided that is connected to the substrate 2 using bond pads 14 on the substrate 2 and bond pads 32 on the separate substrate. Typically, the separate substrate will be a conventional electronic semiconductor device, not a MEMS device, formed using a conventional semiconductor process. Bond wires 34 between bond pads 14, 32 may be used to electrically connect the substrates 2, 30 together. Alternative connection processes, for example directly bonding the two substrates together may be used.

In the embodiment, the bipolar transistor is used as an ESD protection device attached to the bond pads 14 on substrate 2. The size of the device is determined by the necessary current carrying capacity. In the embodiment, assuming a pnp device and spacing of 2 µm between collector 8 and emitter 10, the ESD protection device has a current carrying capability of about 1 mA for each 1 µm of length. For a suitable ESD pulse of 1A, a device of 1000 µm, i.e. 1 mm, width is required, of similar size to a bond pad.

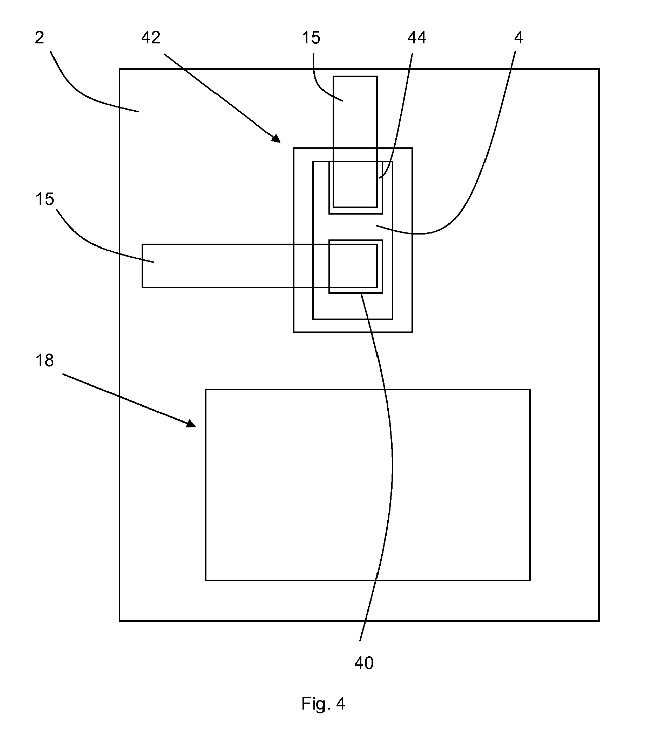

In an alternative embodiment (Figure 4) the same process steps are used to form a diode-type ESD protection diode 42, with a p-n junction, using the step 26 forming a shallow contact 40 of opposite conductivity type to the well 4 to define the p-type and n-type regions using the junction between the well 4 and shallow contact 40 of opposite conductivity type as the p-n junction. The well 4 is contacted using a shallow contact 44 of the same conductivity type as the well 4.

Alternatively or additionally, a bipolar device manufactured as discussed above with relation to Figures 1 to 3 may be used as an integrated amplifier on substrate 2.

In a particular version of this arrangement, a piezo-resistive MEMS element 18 may be formed on a single substrate 2 using bipolar transistor 16 formed as above as part of a feedback loop. Alternative MEMS devices may also be used, including for example capacitive devices.

The substrate 2 may be a silicon on insulator substrate. In this case, the substrate includes an insulating buried oxide layer which permits very high voltages relative to the substrate, such as 100V or more, using compact insulation (for example 1 µm buried oxide) instead of thick depleted junctions which may have a thickness ten times higher. The 100V may be compared with a typical 50V limit for the substrate insulation pn junction in other technologies.

The use of high voltages is an advantage for MEMS as the actuation force over a vacuum electrode increases for large bias voltage, and the capactive readout signal may be proportional to the bias voltage. Accordingly, a high bias voltage amplifies the change of sensing capacitance.

Silicon on insulator is also an advantage for bipolar transistors since leakage currents to the substrate are not a problem. This gives particular benefits at high temperatures.

## Claims

1. A method of manufacturing a MEMS device on a MEMS substrate (2), comprising:
forming a MEMS element (18) using a series of steps including a step (22) of forming a well of a first conductivity type and a step (24) of forming a shallow contact of the same first conductivity type at locations determined by a first mask;
further comprising forming a bipolar transistor (16,42) and/or ESD protection device (16) using a step (26) of forming a shallow contact (8,10,40) of a second conductivity type opposite to the first conductivity type at locations determined by a second mask.

2. A method according to claim 1 including forming a bipolar transistor with base (4), base contact (6), collector (8) and emitter (10), the base (4) being formed in the step (22) of forming a well of first conductivity type and the base contact (6) being formed in contact with the base in the step (24) of forming a shallow contact of the same first conductivity type, and the collector (8) and emitter (10) being formed in the step (26) of forming a shallow contact of second conductivity type, the collector and emitter being formed adjacent to the base.

3. A method according to claim 2 further comprising forming (20) an isolation trench (12) around the bipolar transistor.

4. A method according to claim 2 or 3 wherein the bipolar transistor (16) forms an ESD protection device.

5. A method according to any preceding claim including forming a diode-type ESD protection device (42) including a pn junction formed between the well (4) of first conductivity type and the shallow contact (40) of second conductivity type.

6. A method according to any preceding claim further comprising providing a separate substrate (30) with electronic circuitry and electrically connecting the separate substrate (30) with electronic circuitry to the MEMS device on the MEMS substrate (2).

7. A method according to any of claims 2 to 4 wherein the bipolar transistor (16) is connected as a feedback amplifier, further comprising connecting the feedback amplifier to the MEMS element (18) to form a resonator on a single substrate (2).

8. A MEMS device comprising:
wells (4) of a first conductivity type, shallow contacts (6,44) of the same first conductivity type and at least one shallow contact (8,10,40) of a second conductivity type;
comprising a MEMS element (18) formed with at least one of the wells (4) of a first conductivity type and contacts formed by the shallow contacts (6,44) of the same first conductivity type; and
further comprising at least one bipolar transistor and/or ESD device (16,40) formed with at least one of the wells (4) of a first conductivity type, at least one shallow contact (8,10,40) of a second conductivity type and at least one of the shallow contacts (6,44) of the same first conductivity type contacting the at least one of the wells of a first conductivity type.

9. A MEMS device according to claim 8 comprising a bipolar transistor (16) formed with a base (4) being one of the wells of a first conductivity type, a base contact (6) to the base being one of the shallow contacts of a first conductivity type and an emitter (8) and collector (10) being respective shallow contacts of a second conductivity type.

10. A MEMS device according to claim 8 further comprising an isolation trench (12) around the bipolar transistor.

11. A MEMS device according to any of claims 8 to 10 further comprising a diode-type ESD protection device (40) including a p-n junction formed between a well of first conductivity type and a shallow contact of second conductivity type.

12. A MEMS device according to claim 9 or 10 wherein the bipolar transistor (16) is a feedback amplifier connected to the MEMS element (18) forming a resonator on a single substrate.
